# EUROPÄISCHE PATENTSCHRIFT

(11) **EP 0 557 741 B1**
(45) Veröffentlichungstag und Bekanntmachung des Hinweises auf die Patenterteilung: **10.04.1996**
(21) Anmeldenummer: 93101537.4
(22) Anmeldetag: 02.02.1993
(51) Int. Cl.: H03D 7/14

(54) **HF-Mischstufe in Basisschaltung**
HF mixer stage in common base
Etage mélangeur HF à base commun

(30) Priorität: 28.02.1992 DE 4206164
(43) Veröffentlichungstag der Anmeldung: 01.09.1993
(73) Patentinhaber: TEMIC TELEFUNKEN microelectronic GmbH, D-74072 Heilbronn (DE)
(72) Erfinder: Rinderle, Heinz, W-7100 Heilbronn (DE); Sapotta, Hans, Dr., W-7100 Heilbronn (DE)
(74) Vertreter: Maute, Hans-Jürgen, Dipl.-Ing.

(56) Entgegenhaltungen:
- EP-A- 0 073 929
- US-A- 4 080 573
- US-A- 4 310 810

## Beschreibung

Multiplikative Mischstufen zur Frequenzumsetzung werden im HF-Bereich vielfältig eingesetzt - beispielsweise wird in Radios nach dem Superheterodyn-Empfängerprinzip das empfangene HF-Signal in die Zwischenfrequenzebene (ZF-Ebene) umgesetzt. Derartige multiplikative Mischstufen bestehen aus einem "aktiven Teil" mit einer (Differenz-) Verstärkerstufe mit zwei Verstärkertransistoren, denen jeweils zwei Schalttransistoren zugeordnet sind, sowie aus Schaltungsmitteln zur phasenrichtigen Addition der Ströme durch die Schalttransistoren; die Verstärkertransistoren werden dabei entweder in Emitterschaltung (Gilbert-Zelle) oder - für höhere Transitfrequenzen - in Basisschaltung realisiert. Solche Mischstufen sind beispielsweise aus EP-A-0 073 929 bekannt.

Ein Nachteil derartiger Schaltungsanordnungen ist die recht geringe Großsignalfestigkeit - beispielsweise bei Radio-Empfängern wirkt sich dies als Dynamikverlust auf die gesamte Signalverarbeitung aus und stellt angesichts der wachsenden Senderdichte ein gravierendes Problem dar. Darüber hinaus müssen bekannte Mischstufen in Basisschaltung immer symmetrisch angesteuert werden; falls sie jedoch (asymmetrische) Eintaktsignale verarbeiten sollen - beispielsweise bei Radio-Empfängern ist der Schwingkreis zwischen Vorstufe und Mischstufe unsymmetrisch -, sind zusätzliche Symmetrierglieder erforderlich.

Der Erfindung liegt die Aufgabe zugrunde, eine HF-Mischstufe in Basisschaltung gemäß dem Oberbegriff des Patentanspruchs 1 anzugeben, die eine gute Großsignalfestigkeit aufweist und bei der eine asymmetrische Einspeisung des Eingangssignals möglich ist.

Diese Aufgabe wird erfindungsgemäß durch die Merkmale im Kennzeichen des Patentanspruchs 1 gelöst.

Vorteilhafte Weiterbildungen der Erfindung ergeben sich aus den Unteransprüchen.

Bei der erfindungsgemäßen HF-Mischstufe ist die Verstärkerstufe des "aktiven Teils" nicht als Differenzverstärker ausgebildet - vielmehr wird die Differenzbildung aufgrund des unterschiedlichen Leitfähigkeitstyps der beiden Verstärkertransistoren erreicht. Von den Verstärkertransistoren wird der aufgeteilte Eingangsstrom den zugeordneten Schalttransistoren der Schaltstufe zugeführt; dazu wird der Kollektor des jeweiligen Verstärkertransistors mit den Emittern der zugeordneten Schalttransistoren verbunden. Die Ausgänge des "aktiven Teils" der Mischstufe werden durch die Kollektoren der Schalttransistoren gebildet. Um die korrekte Multiplikation des Eingangssignals mit dem Oszillatorsignal zu gewährleisten, müssen die Ausgangsströme des aktiven Teils der Mischstufe (die Kollektorströme der Schalttransistoren) durch entsprechende Schaltungsmittel phasenrichtig addiert werden - beispielsweise mittels eines Transformators mit 3 Wicklungen, mittels einer integrierbaren Schaltung aus Widerständen und Kondensatoren oder mittels einer Stromspiegelschaltung.

Die erfindungsgemäße Schaltungsanordnung vereinigt mehrere Vorteile in sich:
- Die Großsignalfestigkeit kann bedeutend verbessert und damit auch die Dynamik des Empfangsteils gesteigert werden; dies bedeutet, daß die Linearität der Signalübertragung erhöht wird, was sich beispielsweise im Intermodulation-Verhalten äußert - der "Interception Point" kann beispielsweise beträchtlich gesteigert oder/und gleichzeitig der Strombedarf verringert werden.
- Da die Schaltung nur einen Eingang aufweist, ist eine Eintaktansteuerung bzw. asymmetrische Einspeisung des Eingangssignals möglich; auf Symmetrierglieder kann verzichtet werden.

Die Erfindung soll weiterhin anhand der Figuren 1 bis 5 beschrieben werden.

Es zeigen:
- Figur 1: eine Schaltungsanordnung als Ausführungsbeispiel des HF-Mischers.
- Figur 2: eine Schaltungsanordnung als weiteres Ausführungsbeispiel des HF-Mischers für niedere Betriebsspannungen.
- Figur 3: ein Ausführungsbeispiel für die Schaltungsmittel zur phasenrichtigen Addition der Ausgangsströme.
- Figur 4: ein anderes Ausführungsbeispiel für die Schaltungsmittel zur phasenrichtigen Addition der Ausgangsströme.
- Figur 5: ein weiteres Ausführungsbeispiel für die Schaltungsmittel zur phasenrichtigen Addition der Ausgangsströme.

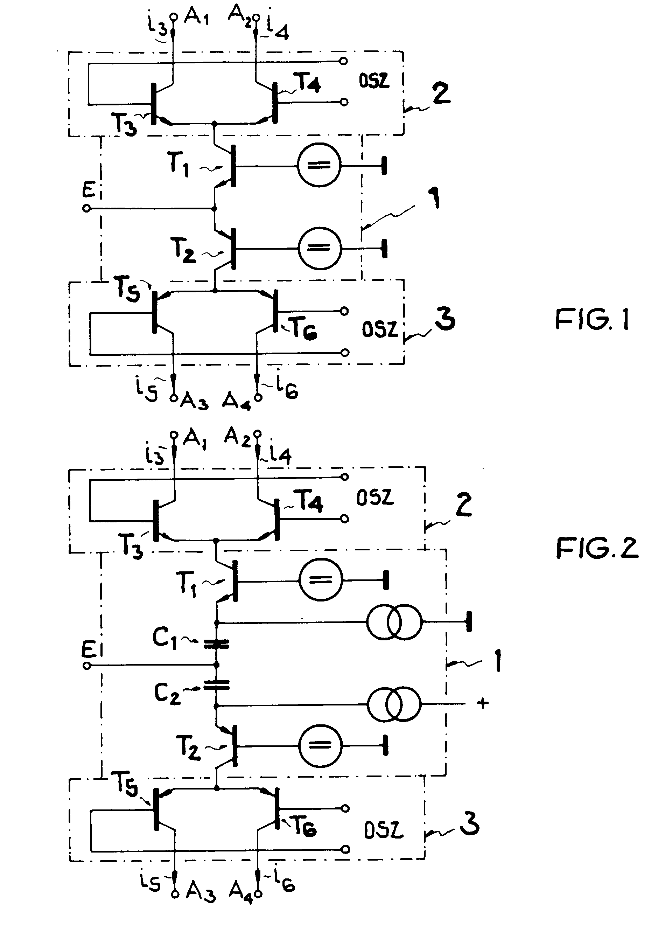

Gemäß der Figur 1 besteht die Verstärkerstufe 1 aus den beiden emittergekoppelten Verstärkertransistoren T₁ und T₂, wobei durch den Kopplungspunkt der beiden Emitter der Schaltungseingang E gebildet wird; an diesem wird das HF-Eingangssignal eingespeist. Die Arbeitspunkte der beiden Verstärkertransistoren T₁ und T₂ können auf vielfältige Art vorgegeben werden: beispielsweise (siehe Figur 1) mittels Vorspannung der Basen der Verstärkertransistoren T₁ und T₂; oder aber (zur Stabilisierung der Arbeitspunkteinstellung) mittels zweier Widerstände, von denen einer die Emitter der beiden Verstärkertransistoren T₁ und T₂ verbindet und der andere mit der Basis des zweiten Verstärkertransistors T₂ gegen Bezugspotential verbunden ist. An den Kollektor des ersten Verstärkertransistors T₁ ist die erste Schaltstufe 2 mit den beiden emittergekoppelten Transistoren T₃ und T₄ angeschlossen, an den Kollektor des zweiten Verstärkertransistors T₂ ist die zweite Schaltstufe 3 mit den beiden emittergekoppelten Schalttransistoren T₅ und T₆ angeschlossen. Den Basen der Schalttransistoren T₃ - T₆ werden neben geeigneten Vorspannungssignalen die Überlagerungssignale, beispielsweise das Signal eines Oszillators OSZ zugeführt, die Kollektoren der Schalttransistoren T₃, T₄, T₅, T₆ (an diesen fließen die Ausgangsströme i₃, i₄, i₅, i₆) bilden die Summierausgänge A₁, A₂, A₃ und A₄ des "aktiven Teils" der Mischstufe. Die beiden Verstärkertransistoren T₁ und T₂ sind vom komplementären Leitungstyp, wobei gemäß der Figur der (mit dem positiven Pol der Schaltung verbundene) erste Verstärkertransistor T₁ ein NPN-Transistor und der (mit dem negativen Pol der Schaltung verbundene) zweite Verstärkertransistor T₂ ein PNP-Transistor ist. Die Schalttransistoren des Transistorpaars 2 bzw. 3 sind vom gleichen Leitfähigkeitstyp wie der Verstärkertransistor T₁ bzw. T₂, dem sie zugeordnet sind; demnach sind die beiden Schalttransistoren T₃ und T₄ des ersten Transistorpaares 2 NPN-Transistoren, während die Schalttransistoren T₅ und T₆ des zweiten Transistorpaares 3 als PNP-Transistoren ausgebildet sind. Gemäß der Figur 2 ist eine Variante der Schaltungsanordnung der Figur 1 gezeigt, die auch für niedrige Betriebsspannungen eingesetzt werden kann; dies wird dadurch sichergestellt, daß im Gegensatz zur Schaltungsanordnung der Figur 1 die Transistoren unterschiedlichen Leitfähigkeitstyps bezüglich der Stromversorgung nicht in Serie, sondern parallel geschaltet sind. Durch beide Transistoren fließt ein Gleichstrom vom gleichen Betrag. Die beiden Verstärkertransistoren T₁ und T₂ sind nicht direkt (wie in der Figur 1) mit dem Schaltungseingang E verbunden, sondern wegen unterschiedlicher Gleichspannungspotentiale jeweils über einen Kondensator C₁ bzw. C₂. Weiterhin ist zur Arbeitspunkteinstellung jeweils am Emitter der beiden Verstärkertransistoren T₁ bzw. T₂ eine mit Bezugspotential bzw. Betriebsspannung verbundene Stromquelle angeschlossen.

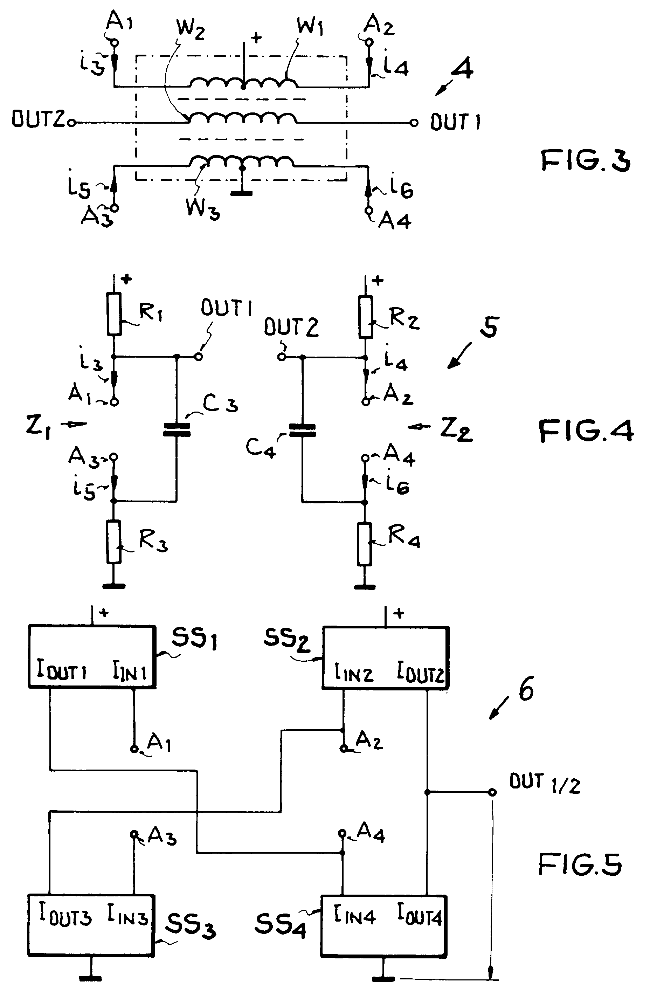

Damit die gewünschte Linearisierung im Übertragungsverhalten erreicht wird, müssen die Ausgangsströme i₃ - i₆ an den Summierausgängen A₁ - A₄ des "aktiven Teils" der Mischstufe phasenrichtig addiert werden bzw. muß das Eingangssignal mit dem Signal des Oszillators OSZ korrekt multipliziert werden. Um dies zu gewährleisten, sind in den Figuren 3 bis 5 die Schaltungsanordnungen dreier Ausführungsbeispiele gezeigt.

In der Figur 3 ist dazu ein Transformator 4 mit 3 Wicklungen W₁, W₂ und W₃ vorgesehen: die erste Wicklung W₁ mit Mittenanzapfung gegenüber der Betriebsspannung ist mit den beiden Summiereingängen A₁ und A₂ der Mischstufe verbunden, die dritte Wicklung W₃ mit Mittenanzapfung gegen Bezugspotential ist mit den beiden Summierausgängen A₃ und A₄ der Mischstufe verbunden, die beiden Anschlüsse der mittleren Wicklung W₂ bilden die beiden Ausgänge der Mischstufe OUT₁ bzw. OUT₂.

Gemäß der Figur 4 ist ein integrierbares Netzwerk 5 aus Widerständen R₁ - R₄ und Kondensatoren C₃ und C₄ vorgesehen. Das Netzwerk bildet zwei gleiche, symmetrisch aufgebaute Zweige Z₁ und Z₂, wobei in den beiden Zweigen Z₁ bzw. Z₂ jeweils zwei Widerstände R₁, R₃ bzw. R₂, R₄ kapazitiv über einen Kondensator C₃ bzw. C₄ gekoppelt sind. Ein Anschluß des ersten Widerstandes R₁ bzw. R₂ ist an die Betriebsspannung angeschlossen, ein Anschluß des zweiten Widerstandes R₃ bzw. R₄ ist mit Bezugspotential verbunden. Die beiden anderen Anschlüsse der Widerstände R₁, R₃ bzw. R₂, R₄ sind sowohl über den Kondensator C₃ bzw. C₄ miteinander als auch jeweils mit einem der Summierausgänge A₁ - A₄ verbunden. Die beiden Ausgänge OUT₁ bzw. OUT₂ der Mischstufe werden durch den mit dem Kondensator C₃ bzw. C₄ verbundenen Anschluß der ersten Widerstände R₁ bzw. R₃ gebildet.

Gemäß der Figur 5 ist eine Stromspiegel-Schaltungsanordnung 6 aus vier mittels bipolaren Transistoren aufgebauten Stromspiegeln SS₁, SS₂, SS₃ und SS₄ vorgesehen, die zwei Stromspiegelpaare SS₁, SS₂ bzw. SS₃, SS₄ mit untereinander verschiedenem Leitfähigkeitstyp bilden. Die beiden Stromspiegel SS₁, SS₂ des ersten Stromspiegelpaares sind an Betriebsspannung angeschlossen, die beiden Stromspiegel SS₃, SS₄ des zweiten Stromspiegelpaares sind mit Bezugspotential verbunden. Der Summierausgang A₁ bzw. A₂ ist mit dem Eingang I_{IN1} bzw. I_{IN2} des Stromspiegels SS₁ bzw. SS₂ des ersten Stromspiegelpaares, der Summierausgang A₃ bzw. A₄ mit dem Eingang I_{IN3} bzw. I_{IN4} des Stromspiegels SS₃ bzw. SS₄ des zweiten Stromspiegelpaares verbunden. Weiterhin ist der Eingang I_{IN2} bzw. I_{IN4} des jeweils zweiten Stromspiegels SS₂ bzw. SS₄ der beiden Stromspiegelpaare mit dem Ausgang I_{OUT1} bzw. I_{OUT3} des jeweils ersten Stromspiegels SS₁ bzw. SS₃ der beiden Stromspiegelpaare verbunden. Der (Eintakt-) Ausgang OUT_{1/2} der Mischstufe wird durch die beiden miteinander verbundenen Ausgänge I_{OUT2}, I_{OUT4} der zweiten Stromspiegel SS₂, SS₄ der beiden Stromspiegelpaare gebildet.

Mit der vorgestellten Schaltung kann die Linearität der Übertragung (die sich beispielweise im Intermodulationsverhalten bzw. Interception Point äußert) bedeutend erhöht werden bzw. der benötigte Strom reduziert werden; gleichzeitig wird jedoch das Rauschverhalten nicht verschlechtert.

Daher wird die Schaltung vorzugsweise überall dort eingesetzt, wo eine hohe Linearität und/oder ein geringer Strombedarf benötigt wird. Als Beispiele hierzu seien beispielsweise Cordless-Telefon-Anwendungen, Empfängerschaltungen, die nach dem Prinzip der Direktmischung arbeiten, Phasenkomparatoren, hochlineare Multipliziererschaltungen etc. genannt.

## Patentansprüche

1. HF-Mischstufe in Basisschaltung, bestehend aus einer Verstärkerstufe (1) mit zwei Verstärkertransistoren (T₁, T₂), aus einer Schaltstufe mit zwei Transistorpaaren (2, 3) mit jeweils zwei emittergekoppelten Schalttransistoren (T₃, T₄ bzw. T₅, T₆) und aus mit den Schalttransistoren (T₃ - T₆) verbundenen Schaltungsmitteln (4, 5, 6) zur phasenrichtigen Addition der Ströme durch die Schalttransistoren, wobei die Schalttransistoren (T₃, T₄ bzw. T₅, T₆) eines Transistorpaares (2 bzw. 3) an den Kollektor des zugeordneten Verstärkertransistors (T₁ bzw. T₂) angeschlossen sind, und wobei die Basen der Schalttransistoren (T₃, T₄ bzw. T₅, T₆) mit einem Überlagerungssignal (OSZ) beaufschlagt werden, dadurch gekennzeichnet, daß die beiden Verstärkertransistoren (T₁, T₂) vom entgegengesetzten Leitfähigkeitstyp sind, daß die Emitter der Verstärkertransistoren (T₁, T₂) mit dem Schaltungseingang (E) verbunden sind, und daß die beiden Schalttransistoren (T₃, T₄ bzw. T₅, T₆) eines Transistorpaares (2 bzw. 3) den gleichen Leitfähigkeitstyp wie der zugeordnete Verstärkertransistor (T₁ bzw. T₂) besitzen.

2. Mischstufe nach Anspruch 1, dadurch gekennzeichnet, daß die Emitter der Verstärkertransistoren (T₁, T₂) direkt mit dem Schaltungseingang (E) verbunden sind, und daß die beiden Verstärkertransistoren (T₁, T₂) gleichstrommäßig hintereinander geschaltet sind.

3. Mischstufe nach Anspruch 1, dadurch gekennzeichnet, daß die Emitter der Verstärkertransistoren (T₁, T₂) jeweils über Schaltungsmittel mit dem Schaltungseingang (E) verbunden sind, und daß die beiden Verstärkertransistoren (T₁, T₂) in gleichstrommäßig parallelen Anordnungen liegen.

4. Mischstufe nach Anspruch 3, dadurch gekennzeichnet, daß als Schaltungsmittel zwei Kondensatoren (C₁, C₂) vorgesehen sind, die jeweils zwischen dem Emitter eines Verstärkertransistors (T₁, T₂) und dem Schaltungseingang (E) angeordnet sind.

5. Mischstufe nach einem der Ansprüche 1 bis 4, dadurch gekennzeichnet, daß die Kollektoren der Schalttransistoren (T₃ - T₆) Summierausgänge (A₁ - A₄) bilden.

6. Mischstufe nach einem der Ansprüche 1 bis 5, dadurch gekennzeichnet, daß die Schaltungsmittel (4, 5, 6) an den Summierausgängen (A₁ - A₄) angeschlossen sind, und daß die beiden Ausgänge (OUT₁, OUT₂) der Mischstufe vermöge dieser Schaltungsmittel (4, 5, 6) gebildet werden.

7. Mischstufe nach Anspruch 6, dadurch gekennzeichnet, daß die Schaltungsmittel (4, 5, 6) derart ausgebildet sind, daß durch phasenrichtige Addition der Kollektorströme (i₃, i₄, i₅, i₆) der Schalttransistoren (T₃, T₄, T₅, T₆) das am Schaltungseingang (E) anliegende Eingangssignal mit dem Signal des Oszillators (OSZ) multipliziert und an den Ausgängen (OUT₁, OUT₂) der Mischstufe ausgegeben wird.

8. Mischstufe nach Anspruch 6 oder 7, dadurch gekennzeichnet, daß als Schaltungsmittel ein Transformator (4) mit 3 Wicklungen vorgesehen ist.

9. Mischstufe nach Anspruch 8, dadurch gekennzeichnet, daß eine Wicklung (W₁) des Transformators (4) mit Mittenanzapfung gegen den einen Pol der Betriebsspannung mit den Summierausgängen (A₁, A₂) der Schalttransistoren (T₃, T₄) des ersten Transistorpaares (2) und eine Wicklung (W₃) des Transformators (4) mit Mittenanzapfung gegen den anderen Pol der Betriebsspannung (Bezugspotential) mit den Summierausgängen (A₃, A₄) der Schalttransistoren (T₅, T₆) des zweiten Transistorpaares (3) verbunden ist, und daß jeweils ein Anschluß der dritten Wicklung (W₂) des Transformators (4) einen Ausgang (OUT₁ bzw. OUT₂) der Mischstufe bildet.

10. Mischstufe nach Anspruch 6 oder 7, dadurch gekennzeichnet, daß als Schaltungsmittel eine integrierbare Schaltung (5) aus Widerständen (R₁ - R₄) und Kondensatoren (C₃, C₄) vorgesehen ist.

11. Mischstufe nach Anspruch 10, dadurch gekennzeichnet, daß die integrierbare Schaltung (5) aus zwei gleichen, symmetrisch aufgebauten Zweigen (Z₁ bzw. Z₂) mit jeweils einem Kondensator (C₃ bzw. C₄) und zwei Widerständen (R₁, R₃ bzw. R₂, R₄) besteht, daß jeweils ein Anschluß des ersten Widerstandes (R₁ bzw. R₂) eines Zweiges (Z₁ bzw. Z₂) an den einen Pol der Betriebsspannung und ein Anschluß des zweiten Widerstandes (R₃ bzw. R₄) eines Zweiges (Z₁ bzw. Z₂) an den anderen Pol der Betriebsspannung (Bezugspotential) angeschlossen ist, daß die jeweils anderen Anschlüsse der beiden Widerstände (R₁, R₃ bzw. R₂, R₄) eines Zweiges (Z₁ bzw. Z₂) über den Kondensator (C₃ bzw. C₄) kapazitiv gekoppelt sind, und daß jeweils der zweite Anschluß des ersten Widerstands (R₁ bzw. R₂) eines Zweiges (Z₁ bzw. Z₂) einen Ausgang (OUT₁, OUT₂) der Mischstufe bildet.

12. Mischstufe nach Anspruch 6 oder 7, dadurch gekennzeichnet, daß als Schaltungsmittel eine Stromspiegelschaltung (6) vorgesehen ist.

13. Mischstufe nach Anspruch 12, dadurch gekennzeichnet, daß die Stromspiegelschaltung (6) aus vier mittels bipolaren Transistoren aufgebauten Stromspiegeln (SS₁, SS₂, SS₃, SS₄) besteht, die zwei gleiche Stromspiegelpaare (SS₁, SS₂ bzw. SS₃, SS₄) mit unterschiedlichem Leitfähigkeitstyp bilden, daß die beiden Stromspiegel (SS₁, SS₂) des ersten Stromspiegelpaares an den einen Pol der Betriebsspannung und die beiden Stromspiegel (SS₃, SS₄) des zweiten Transistorpaares an den anderen Pol der Betriebsspannung (Bezugspotential) angeschlossen sind, daß jeweils ein Summierausgang (A₁, A₂, A₃, A₄) mit dem Eingang (I_{IN1}, I_{IN2}, I_{IN3}, I_{IN4}) eines Stromspiegels (SS₁, SS₂, SS₃, SS₄) verbunden ist, daß der Eingang (I_{IN2} bzw. I_{IN4}) des jeweils zweiten Stromspiegels (SS₂ bzw. SS₄) eines Transistorpaares mit dem Ausgang (I_{OUT3} bzw. I_{OUT1}) des jeweils ersten Stromspiegels (SS₁ bzw. SS₃) des anderen Transistorpaares verbunden ist, und daß der Ausgang (OUT_{1/2}) der Mischstufe durch die beiden miteinander verbundenen Ausgänge (I_{OUT2}, I_{OUT4}) der zweiten Stromspiegel (SS₂, SS₄) eines Transistorpaares gebildet wird.

14. Schaltungsanordnung nach einem der Ansprüche 1 bis 13, dadurch gekennzeichnet, daß der erste Verstärkertransistor (T₁) und die Schalttransistoren (T₃, T₄) des ersten Transistorpaares (2) NPN-Transistoren sind, und daß der zweite Verstärkertransistor (T₂) und die Schalttransistoren (T₅, T₆) des zweiten Transistorpaares (3) PNP-Transistoren sind.

## Claims

1. A HF mixer stage with a common base connection consisting of an amplifier stage (1) with two amplifier transistors (T₁, T₂), a switching stage with two pairs of transistors (2, 3) in each case comprising two emittercoupled switching transistors (T₃, T₄ and T₅, T₆) and circuit means (4, 5, 6), connected to the switching transistors (T₃ - T₆) for the phase-correct addition of the currents through the switching transistors, where the switching transistors (T₃, T₄ and T₅, T₆) of a pair of transistors (2 and 3) are connected to the collector of the associated amplifier transistor (T₁ and T₂), and where the bases of the switching transistors (T₃, T₄ and T₅, T₆) are supplied with a superimposed signal (OSZ), characterised in that the two amplifier transistors (T₁, T₂) are of the opposite conductivity type, that the emitters of the amplifier transistors (T₁, T₂) are connected to the circuit input (E), and that the two switching transistors (T₃, T₄, and T₅, T₆) of a pair of transistors (2 and 3) possess the same conductivity type as the associated amplifier transistor (T₁ and T₂).

2. A mixer stage as claimed in Claim 1, characterised in that the emitters of the amplifier transistors (T₁, T₂) are directly connected to the circuit input (E) and that the two amplifier transistors (T₁, T₂) are connected in series with one another in respect of direct current.

3. A mixer stage as claimed in Claim 1, characterised in that the emitters of the amplifier transistors (T₁, T₂) are in each case connected to the circuit input (E) via circuit means and that the two amplifier transistors (T₁, T₂) are located in arrangements which are parallel in respect of direct current.

4. A mixer stage as claimed in Claim 3, characterised in that two capacitors (C₁, C₂) are provided as circuit means, which capacitors are in each case arranged between the emitter of an amplifier transistor (T₁, T₂) and the circuit input (E).

5. A mixer stage as claimed in one of Claims 1 to 4, characterised in that the collectors of the switching transistors (T₃ - T₆) form summing outputs (A₁ - A₄).

6. A mixer stage as claimed in one of Claims 1 to 5, characterised in that the circuit means (4, 5, 6) are connected to the summing outputs (A₁ - A₄), and that the two outputs (OUT₁, OUT₂) of the mixer stage are formed by virtue of these circuit means (4, 5, 6).

7. A mixer stage as claimed in Claim 6, characterised in that the circuit means (4, 5, 6) are designed in such manner that by the phase-correct addition of the collector currents (i₃, i₄, i₅, i₆) of the switching transistors (T₃, T₄, T₅, T₆), the input signal occurring at the circuit input (E) is multiplied by the signal of the oscillator (OSZ) and is output at the outputs (OUT₁, OUT₂) of the mixer stage.

8. A mixer stage as claimed in Claim 6 or 7, characterised in that a transformer (4) with three windings is provided as circuit means.

9. A mixer stage as claimed in Claim 8, characterised in that a winding (W₁) of the transformer (4) with a central tapping to the first pole of the operating voltage is connected to the summing outputs (A₁, A₂) of the switching transistors (T₃, T₄) of the first pair of transistors (2), and a winding (W₃) of the transformer (4) with a central tapping to the other pole of the operating voltage (reference potential) is connected to the summing outputs (A₃, A₄) of the switching transistors (T₅, T₆) of the second pair of transistors (3), and that a terminal of the third winding (W₂) of the transformer (4) in each case forms an output (OUT₁ and OUT₂) of the mixer stage.

10. A mixer stage as claimed in Claim 6 or 7, characterised in that an integrable circuit (5) comprising resistors (R₁-R₄) and capacitors (C₃, C₄) is provided as circuit means.

11. A mixer stage as claimed in Claim 10, characterised in that the integrable circuit (5) consists of two identical, symmetrically constructed arms (Z₁ and Z₂) in each case comprising a capacitor (C₃ and C₄) and two resistors (R₁, R₃ and R₂, R₄), that in each case one terminal of the first resistor (R₁ and R₂) of an arm (Z₁ and Z₂) is connected to the one pole of the operating voltage, and one terminal of the second resistor (R₃ and R₄) of an arm (Z₁ and Z₂) is connected to the other pole of the operating voltage (reference potential), and that the respective other terminals of the two resistors (R₁, R₃ and R₂, R₄) of an arm (Z₁ and Z₂) are capacitively coupled via the capacitor (C₃ and C₄), and that in each case the second terminal of the first resistor (R₁ and R₂) of an arm (Z₁ and Z₂) forms an output (OUT₁, OUT₂) of the mixer stage.

12. A mixer stage as claimed in Claim 6 or 7, characterised in that a current mirror circuit (6) is provided as circuit means.

13. A mixer stage as claimed in Claim 12, characterised in that the current mirror circuit (6) consists of four current mirrors (SS₁, SS₂, SS₃, SS₄) which are constructed by means of bipolar transistors and which form two identical pairs of current mirror (SS₁, SS₂ and SS₃, SS₄) with a different conductivity type, that the two current mirrors (SS₁, SS₂) of the first pair of current mirrors are connected to the one pole of the operating voltage and the two current mirrors (SS₃, SS₄) of the second pair of transistors are connected to the other pole of the operating voltage (reference potential), that a summing output (A₁, A₂, A₃, A₄) is in each case connected to the input (I_{IN1}, I_{IN2}, I_{IN3}, I_{IN4}) of a current mirror (SS₁, SS₂, SS₃, SS₄), that the input (I_{IN2} and I_{IN4}) of the respective second current mirror (SS₂ and SS₄) of a pair of transistors is connected to the output (I_{OUT3} and I_{OUT1}) of the respective first current mirror (SS₁ and SS₃) of the other pair of transistors, and that the output (OUT_{1/2}) of the mixer stage is formed by the two interconnected outputs (I_{OUT2}, I_{OUT4}) of the second current mirrors (SS₂, SS₄) of a pair of transistors.

14. A circuit arrangement as claimed in one of Claims 1 to 13, characterised in that the first amplifier transistor (T₁) and the switching transistors (T₃, T₄) of the first pair of transistors (2) are NPN- transistors and that the second amplifier transistor (T₂) and the switching transistors (T₅, T₆) of the second pair of transistors (3) are PNP- transistors.

## Revendications

1. Etage mélangeur HF en base commune se composant d'un étage amplificateur (1) équipé de deux transistors amplificateurs (T₁, T₂), d'un étage de commutation équipé de deux paires de transistors (2, 3) avec chacune deux transistors de commutation à émetteurs couplés (T₃, T₄ ou T₅, T₆) et de moyens de circuit (4, 5, 6) reliés aux transistors de commutation (T₃-T₆) en vue de l'addition en phase correcte des courants par les transistors de commutation, les transistors de commutation (T₃, T₄ ou T₅, T₆) d'une paire de transistors (2, 3, respectivement) étant reliés au collecteur du transistor amplificateur associé (T₁ ou T₂), et les bases des transistors de commutation (T₃, T₄ ou T₅, T₆) étant alimentées par un signal de superposition (OSC), caractérisé en ce que les deux transistors amplificateurs (T₁, T₂) sont de types de conductivité opposés, en ce que les émetteurs des transistors amplificateurs (T₁, T₂) sont reliés à l'entrée de circuit (E), et en ce que les deux transistors de commutation (T₃, T₄ ou T₅, T₆) d'une paire de transistors (2 ou 3) possèdent le même type de conductivité que le transistor amplificateur associé (T₁, T₂, respectivement).

2. Etage mélangeur selon la revendication 1, caractérisé en ce que les émetteurs des transistors amplificateurs (T₁, T₂) sont reliés directement à l'entrée de circuit (E), et en ce que les deux transistors amplificateurs (T₁, T₂) sont montés en succession du point de vue courant continu.

3. Etage mélangeur selon la revendication 1, caractérisé en ce que les émetteurs des transistors amplificateurs (T₁ , T₂) sont réunis chacun par l'intermédiaire de moyens de circuit à l'entrée de circuit, et en ce que les deux transistors amplificateurs (T₁, T₂) sont disposés en parallèle du point de vue courant continu.

4. Etage mélangeur selon la revendication 3, caractérisé en ce qu'en tant moyens de circuit, deux condensateurs (C₁, C₂) sont prévus, qui sont disposés chacun entre l'émetteur d'un transistor amplificateur (T₁, T₂) et l'entrée de circuit (E).

5. Etage mélangeur selon l'une quelconque des revendications 1 à 4, caractérisé en ce que les collecteurs des transistors de commutation (T₃-T₆) forment des sorties de sommation (A₁ -A₄).

6. Etage mélangeur selon l'une quelconque des revendications 1 à 5, caractérisé en ce que les moyens de circuit (4, 5, 6) sont reliés aux sorties de sommation (A₁-A₄), et en ce que les deux sorties (OUT₁, OUT₂) de l'étage mélangeur peuvent être formées par ces moyens de circuit (4, 5, 6).

7. Etage mélangeur selon la revendication 6, caractérisé en ce que les moyens de circuit (4, 5, 6) sont réalisés de telle sorte que par addition en phase correcte des courants de collecteur (i₃, i₄, i₅, i₆) des transistors de commutation (T₃, T₄, T₅, T₆), l'entrée de signal appliquée à l'entrée de circuit (E) est multipliée par le signal de l'oscillateur (OSC) et est délivrée aux sorties (OUT₁, OUT₂) de l'étage mélangeur.

8. Etage mélangeur selon la revendication 6 ou 7, caractérisé en ce qu'en tant que moyens de circuit est prévu un transformateur (4) à trois enroulements.

9. Etage mélangeur selon la revendication 8, caractérisé en ce qu'un enroulement (W₁) du transformateur (4) est relié vis-à-vis du premier pôle de la tension de fonctionnement aux sorties de sommation (A₁, A₂) des transistors de commutation (T₃, T₄) de la première paire de transistors (2) et un enroulement (W₃) du transformateur (4) est relié par une prise médiane vis-à-vis de l'autre pôle de la tension de fonctionnement (potentiel de référence) aux sorties de sommation (A₃, A₄) des transistors de commutation (T₅, T₆) de la seconde paire de transistors (3), et en ce que chaque borne du troisième enroulement (W₂) du transformateur (4) forme une sortie (OUT₁ ou OUT₂) de l'étage mélangeur.

10. Etage mélangeur selon la revendication 6 ou 7, caractérisé en ce qu'en tant que moyens de circuit est prévu un circuit intégrable (5) constitué de résistances (R₁-R₄) et de condensateurs (C₃, C₄).

11. Etage mélangeur selon la revendication 10, caractérisé en ce que le circuit intégrable (5) se compose de deux branches identiques, symétriques (Z₁, Z₂, respectivement) avec chacune un condensateur (C₃ ou C₄) et deux résistances (R₁, R₃ ou R₂, R₄), en ce que respectivement une borne de la première résistance (R₁ ou R₂) d'une branche (Z₁ ou Z₂) est reliée à un premier pôle de la tension de fonctionnement et une borne de la seconde résistance (R₃ ou R₄) d'une branche (Z₁ ou Z₂) est reliée à l'autre pôle de la tension de fonctionnement (potentiel de référence), en ce que les autres bornes des deux résistances (R₁, R₃ ou R₂, R₄) d'une branche (Z₁ ou Z₂) sont couplées capacitivement par l'intermédiaire du condensateur (C₃ ou C₄), et en ce que respectivement la seconde borne de la première résistance (R₁ ou R₂) d'une branche (Z₁ ou Z₂) forme une sortie (OUT₁, OUT₂) de l'étage mélangeur.

12. Etage mélangeur selon la revendication 6 ou 7, caractérisé en ce qu'en tant que moyens de circuit est prévu un circuit miroir de courant (6).

13. Etage mélangeur selon la revendication 12, caractérisé en ce que le circuit miroir de courant (6) se compose de quatre miroirs de courant (SS₁, SS₂, SS₃, SS₄) réalisés au moyen de transistors bipolaires, qui forment deux paires de miroirs de courant identiques (SS₁, SS₂ ou SS₃, SS₄) de type de conductivité différent, en ce que les deux miroirs de courant (SS₁, SS₂) de la première paire de miroirs de courant sont reliés au premier pôle de la tension de fonctionnement et les deux miroirs de courant (SS₃, SS₄) de la seconde paire de transistors sont reliés à l'autre pôle de la tension de fonctionnement (potentiel de référence), en ce que respectivement une sortie de sommation (A₁, A₂, A₃, A₄) est reliée à l'entrée (I_{IN1}, I_{IN2}, I_{IN3}, I_{IN4}) d'un miroir de courant (SS₁, SS₂, SS₃, SS₄), en ce que l'entrée (I_{IN2} ou I_{IN4}) du second miroir de courant (SS₂ ou SS₄) d'une paire de transistors est reliée à la sortie (I_{OUT3} ou I_{OUT1}) du premier miroir de courant respectif (SS₁ ou SS₃) de l'autre paire de transistors, et en ce que la sortie (OUT_{1/2}) de l'étage mélangeur est formée par les deux sorties réunies (I_{OUT2}, I_{OUT4}) du second miroir de courant (SS₂, SS₄) d'une paire de transistors.

14. Circuit selon l'une quelconque des revendications 1 à 13, caractérisé en ce que le premier transistor amplificateur (T₁) et les transistors de commutation (T₃, T₄) de la première paire de transistors (2) sont des transistors NPN, et en ce que le second transistor amplificateur (T₂) et les transistors de commutation (T₅, T₆) de la seconde paire de transistors (3) sont des transistors PNP.
